(19) **Europäisches Patentamt**

**European Patent Office**

**Office européen des brevets**

(11) **EP 0 620 648 B1**

(12) **EUROPÄISCHE PATENTSCHRIFT**

(45) Veröffentlichungstag und Bekanntmachung des Hinweises auf die Patenterteilung:
**08.11.2000 Patentblatt 2000/45**

(51) Int. Cl.$^{7}$: **H03K 19/0175**

(21) Anmeldenummer: **94103082.7**

(22) Anmeldetag: **02.03.1994**

(54) **ECL-CMOS-Pegelverschieber**

ECL-CMOS-level shifter

Convertisseur de niveau ECL-CMOS

(84) Benannte Vertragsstaaten:
**DE FR GB IT NL**

(30) Priorität: **12.03.1993 DE 4307856**

(43) Veröffentlichungstag der Anmeldung:
**19.10.1994 Patentblatt 1994/42**

(73) Patentinhaber:
**TEMIC Semiconductor GmbH
74072 Heilbronn (DE)**

(72) Erfinder:
**Sapotta, Hans, Dr. Dipl.-Ing.
D-74078 Heilbronn (DE)**

(74) Vertreter:
**Maute, Hans-Jürgen, Dipl.-Ing. et al
Daimler-Benz Aktiengesellschaft,
FTP/H,
Postfach 35 35
74025 Heilbronn (DE)**

(56) Entgegenhaltungen:
| | |
|---|---|
| **DE-A- 4 308 518** | **US-A- 5 036 226** |
| **US-A- 5 068 551** | **US-A- 5 148 061** |
| **US-A- 5 153 465** | **US-A- 5 182 475** |

**Beschreibung**

Die Erfindung betrifft eine Schaltungsanordnung gemäß dem Oberbegriff des Patentanspruchs 1.

Bipolare Logikschaltungen (Logikpegel typ. 4,5 V ... 5 V) werden heutzutage meist in ECL-Technologie ("Emitter Coupled Logic") ausgeführt, mit der hohe Signalverarbeitungsgeschwindigkeiten realisiert werden können; allerdings sind die hierbei auftretenden statischen Verlustleistungen recht hoch und die zur Verfügung stehenden Spannungspegel nur sehr gering (typ. 0,5 V). Logikschaltungen in MOS-Technologie (Logikpegel typ o ... 5 V) kommen dagegen ohne statische Verlustleistung aus, arbeiten dafür aber nur in niedrigeren Frequenzbereichen (geringe Signalverarbeitungsgeschwindigkeit). In vielen Schaltungsanordnungen - insbesondere in BICMOS-Schaltungen - sind beide Logik-Technologien in separaten Schaltungsteilen vertreten; an ihrer Schnittstelle müssen die Schaltungsteile auf geeignete Weise miteinander verknüpft bzw. aneinander angepaßt werden. Der Weg vom MOS-Schaltungsteil zum ECL-Schaltungsteil ist dabei wegen der damit verbundenen Pegelabschwächung im allgemeinen recht unproblematisch. Der umgekehrte Weg vom ECL-Schaltungsteil zum MOS-Schaltungsteil bereitet jedoch aufgrund der erforderlichen Signalverstärkung und Pegelverschiebung (Anpassung der Logikpegel) größere Schwierigkeiten. Standartschaltungen zur Anpassung des MOS-Schaltungsteils and den ECL-Schaltungsteil - sog. ECL-MOS-Wandler müssen einerseits die notwendige Signalverstärkung und andererseits die erforderliche Pegelverschiebung gewährleisten; sie werden daher meist in MOS-Technologie realisiert und erreichen deshalb nur eine geringe Übertragungsgeschwindigkeit.

Aus der US 5 068 551 ist eine Schaltungsanordnung mit einem ersten Schaltungsteil in ECL-Technologie, einem zweiten Schaltungsteil in MOS-Technologie und einer ECL-MOS-Wandlerstufe bekannt, die als dritter Schaltungsteil den ersten Schaltungsteil mit dem zweiten Schaltungsteil verbindet und den MOS-Schaltungsteil und den ECL-Schaltungsteil anpaßt. Die ECL-MOS-Wandlerstufe umfaßt dabei eine an den ersten Schaltungsteil angeschlossene Impedanzwandlerstufe, eine der Impedanzwandlerstufe nachgeschaltete Verstärkerstufe mit zwei in Gateschaltung betriebenen MOS-Verstärkertransistoren und einer der Verstärkerstufe nachgeschalteten aktiven Lastschaltung, die einen Signalausgang der ECL-MOS-Wandlerstufe bildet. Der wesentliche Nachteil dieser Schaltungsanordnung liegt darin, daß hohe Bauteiletoleranzen zu Funktionsstörungen führen können.

Der Erfindung liegt die Aufgabe zugrunde, eine Schaltungsanordnung gemäß dem Oberbegriff des Patentanspruchs 1 anzugeben, die vorteilhafte Eigenschaften aufweist, insbesondere eine hohe Signal-Übertragungsgeschwindigkeit vom ECL-Schaltungsteil zum MOS-Schaltungsteil, und die einen störungsfreien Betrieb ermöglicht.

Diese Aufgabe wird erfindungsgemäß durch die Merkmale des Patentanspruchs 1 gelöst. Vorteilhafte Weiterbildungen der Erfindung ergeben sich aus den Unteransprüchen.

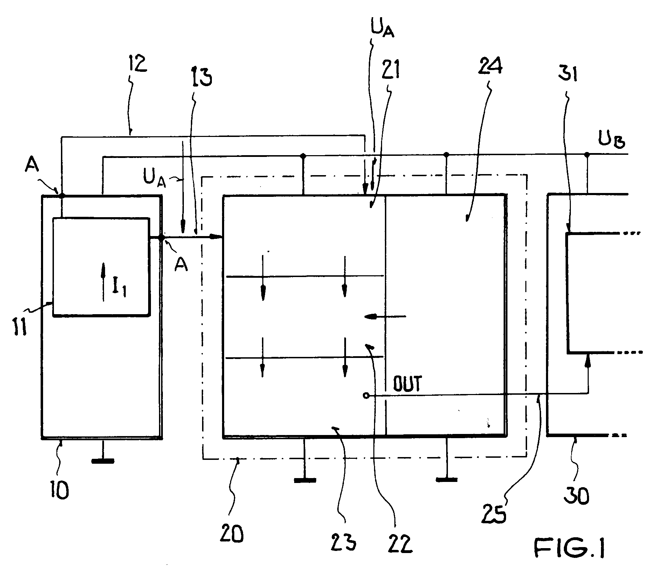

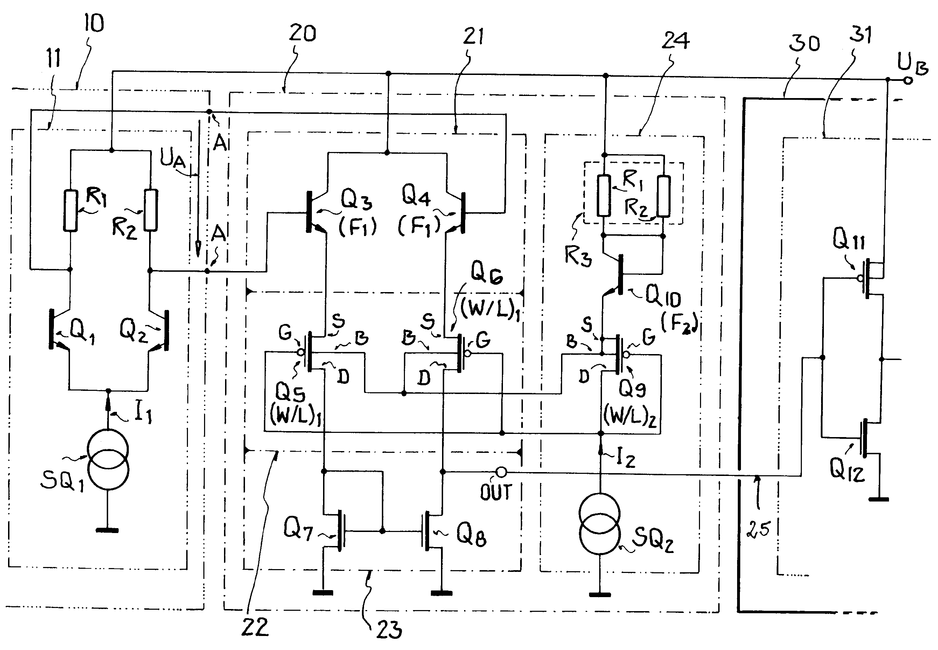

Die Schaltungsanordnung sowie deren Wirkungsweise bzw. Charakteristik soll anhand der Figuren 1 und 2 näher erläutert werden. In der Figur 1 ist dabei das Blockschaltbild der Schaltungsanordnung mit den Schaltungskomponenten und in der Figur 2 ein Ausführungsbeispiel der Schaltungskomponenten dargestellt.

Die Figur 1 zeigt die Schaltungsanordnung mit dem ECL-Schaltungsteil 10, dem MOS-Schaltungsteil 30 und der mit diesen beiden Schaltungsteilen verbundenen ECL-MOS-Wandlerstufe 20. Die Ausgangsstufe 11 des ECL-Schaltungsteils wird vom Referenzstrom $I_1$ versorgt und stellt an ihren Ausgängen A eine Ausgangsspannung $U_A$ als komplementäres Ausgangssignal (Verbindungsleitungen 12, 13) zur Verfügung.

Der MOS-Schaltungsteil 30 mit der Eingangsstufe 31 wird von der gleichen Betriebsspannung $U_B$ wie der ECL-Schaltungsteil 10 versorgt; ihm wird das Ausgangssignal OUT der ECL-MOS-Wandlerstufe 20 über die Verbindungsleitung 25 zugeführt.
Die ECL-MOS-Wandlerstufe 20 besteht aus den Schaltungskomponenten Impedanzwandler 21, Verstärkerstufe 22, aktive Lastschaltung 23 und Referenzzweig 24. Die mit den Ausgängen A des ECL-Schaltungsteils 10 verbundene Impedanzwandlerstufe 21 sorgt für einen hochohmigen und damit rückwirkungsfreien Abgriff der von der ECL-Ausgangsstufe 11 gelieferten Differenzspannung $U_A$. Die Verstärkerstufe 22 ist aus zwei MOS-Verstärkertransistoren (vorzugsweise PMOS-Transistoren) in Gate-Schaltung aufgebaut und dient zur Verstärkung sowie Pegelwandlung der Gegentaktsignale. Die mit dem Ausgang der Verstärkerstufe 22 verbundene aktive Lastschaltung 23 dient zur Phasenaddition der Gegentaktsignale und leitet das Ausgangssignal an ihrem Ausgang OUT an die MOS-Eingangsstufe 31 über die Verbindungsleitung 25 weiter. Der Referenzzweig 24 bildet die Gate-Spannungsverhältnisse der Verstärkertransistoren der Verstärkerstufe 22 nach und stellt diese Gate-Spannung den beiden Verstärkertransistoren zur Verfügung, wodurch der Strom im Verstärkerzweig festgelegt wird.
Die ECL-MOS-Wandlerstufe vereinigt mehrere Vorteile in sich:

- Die beiden Verstärkertransistoren der Verstärkerstufe werden in Gate-Schaltung betrieben, so daß eine hohe Grenzfrequenz der benötigten Signalverstärkung (höhere Geschwindigkeit), eine hohe Aussteuerfähigkeit des Signals, die erforderliche Herabsetzung des DC-Logikpegels und ein höheres Verstärkungs-Bandbreite-Produkt erreicht wird.
- Da durch den Referenzzweig die Spannungsverhältnisse in der Verstärkerstufe nachgebildet werden, steht den Verstärkertransistoren immer die "richtige" Gate-Spannung zur Verfügung; dadurch ist die Schaltungsanordnung voll toleranzkompensiert, d. h. die üblicherweise auftretenden Toleranzen des Referenzstroms, der Lastwiderstände, der Betriebsspannung, der Schwellspannung der MOS-Transistoren und der Temperatur werden automatisch kompensiert.

- Durch die vorgeschaltete Impedanzwandlerstufe kann eine niederohmige Ansteuerung der Verstärkerstufe realisiert werden.
- Durch die aktive Lastschaltung ist eine phasenrichtige Addition der Gegentaktsignale des ECL-Schaltungsteils möglich.

Gemäß der Figur 2 weist die von der Betriebsspannung $U_B$ versorgte Ausgangsstufe 11 des ECL-Schaltungsteils 10 einen Differenzverstärker (Emitter-Koppelelement) aus den beiden bipolaren Transistoren $Q_1$ und $Q_2$ sowie eine Stromquelle $SQ_1$ auf, die die beiden Transistoren $Q_1$, $Q_2$ mit dem Referenzstrom $I_1$ versorgt. An den Kollektoren der Transistoren $Q_1$, $Q_2$ sind die beiden Lastwiderstände $R_1$, $R_2$ angeschlossen, die als ohmsche Widerstände oder als MOS-Transistoren ausgebildet sein können.

Die Eingangsstufe 31 des MOS-Schaltungsteils 30 besteht beispielsweise aus zwei in Source-Schaltung betriebenen MOS-Transistoren (PMOS-Transistor $Q_{11}$, NMOS-Transistor $Q_{12}$), die von der gleichen Betriebsspannung $U_B$ wie der ECL-Schaltungsteil 10 versorgt werden.

Die Impedanzwandlerstufe 21 der ECL-MOS-Wandlerstufe 20 ist als Emitterfolger mit den Transistoren $Q_3$, $Q_4$ ausgebildet, deren Emitterflächen mit $F_1$ bezeichnet ist. Die beiden Emitterfolger-Transistoren $Q_3$, $Q_4$ arbeiten auf die in der Verstärkerstufe 22 angeordneten PMOS-Verstärkertransistoren $Q_5$, $Q_6$ in Gate-Schaltung; die Größe der Transistoren $Q_5$, $Q_6$ (Verhältnis von Kanalweite W zu Kanallänge L) ist mit $(W/L)_1$ angegeben. Als Lastschaltung 23 ist ein NMOS-Stromspiegel mit den Transistoren $Q_7$, $Q_8$ vorgesehen; am Ausgang OUT des Stromspiegels wird das Ausgangssignal über die Verbindungsleitung 25 an die MOS-Eingangsstufe 31 weitergeleitet. Die Gate-Spannung für die beiden PMOS-Verstär-kertransistoren $Q_5$, $Q_6$ wird durch den Referenzzweig 24 bereitgestellt; der Referenzzweig 24 besteht dazu aus einer Serienschaltung von:

- einer Stromquelle $SQ_2$, deren Strom $I_2$ in einem festen Verhältnis n zum Referenzstrom $I_1$ der Stromquelle $SQ_1$ der ECL-Ausgangsstufe 11 steht: $I_2 = n \cdot I_1$.

- einem in Serie zur Stromquelle $SQ_2$ angeordneten PMOS-Kompensationstransistor $Q_9$, dessen Größe $(W/L)_2$ im festen Verhältnis n zu derjenigen der beiden PMOS-Verstärkertransistoren $Q_5$, $Q_6$ steht:

$(W/L)_2 = n \cdot (W/L)_1$. Der PMOS-Kompensationstransistor $Q_9$ weist einen Kurzschluß zwischen seinem Gate-Anschluß G und seinem Drain-Anschluß D auf; am Drain-Anschluß D wird die Gate-Spannung für die beiden aktiven PMOS-Verstärkertransistoren $Q_5$, $Q_6$ abgenommen. Weiterhin besitzt der Transistor $Q_9$ einen Kurzschluß zwischen seiner Source-Elektrode S und seiner Wanne B, mit der die Wannen B der beiden aktiven PMOS-Verstärkertransistoren $Q_5$, $Q_6$ elektrisch verbunden sind. Vorzugsweise werden die Wannen B dieser Transistoren $Q_5$, $Q_6$, $Q_9$ mit dem gleichen NMOS-Wannenprozeß gebildet.

- einem Bipolartransistor $Q_{10}$, der in Serie zum PMOS-Transistor $Q_9$ liegt und einen Kollektor-Basis-Kurzschluß aufweist; durch den Transistor $Q_{10}$ wird der Temperaturgang der Basis-Emitter-Spannung der beiden Emitterfolger-Transistoren $Q_3$ und $Q_4$ kompensiert. Die Emitterfläche $F_2$ des Kompensationstransistors $Q_{10}$ wird abhängig vom Referenzstrom-Verhältnis $I_1$ zu $I_2$ der beiden Stromquellen $SQ_1$ und $SQ_2$ vorgegeben: $F_2 = n \cdot F_1$.

- einem in Serie zum Kompensationstransistor $Q_{10}$ liegenden und an die Betriebsspannung $U_B$ angeschlossenen Widerstand $R_3$, der die Lastwiderstände $R_1$, $R_2$ der beiden Ausgangstransistoren $Q_1$ und $Q_2$ der ECL-Ausgangsstufe 11 nachbildet; die Größe des Widerstands $R_3$ wird so vorgegeben, daß der Spannungsabfall an ihm dem halben Spannungshub an den Widerständen $R_1$ bzw. $R_2$ entspricht. Der Widerstand $R_3$ kann beispielsweise als Parallelschaltung zweier identischer Widerstände ausgebildet werden, die in Typ und Geometrie jeweils den beiden Widerständen $R_1$ oder $R_2$ entsprechen; unter Berücksichtigung des Referenzstrom-Verhältnisses $I_1$ zu $I_2$ (Faktor n) ergibt sich somit für die Wahl des Widerstands $R_3$: $R_3 = 1/n \cdot (R_1, R_2)$.

Der Schaltungsausgang OUT der ECL-MOS-Wandlerstufe 20 wird durch die aktive Lastschaltung 23 gebildet; an diesem kann je nach Dimensionierung der Schaltung ein Spannungshub in der Größenordnung $\frac{1}{2} \cdot U_B$ bis $2/3 \cdot U_B$ erreicht werden. Mit diesem Spannungshub ist das Ansteuern der MOS-Transistoren $Q_{11}$, $Q_{12}$ der Eingangsstufe 31 des MOS-Schaltungsteils 30 möglich.

Falls erforderlich kann der Schaltungsausgang OUT der ECL-MOS-Wandlerstufe 20 auch kapazitiv mit der Eingangsstufe 31 des MOS-Schaltungsteils 30 gekoppelt werden.

**Patentansprüche**

1. Schaltungsanordnung mit:

a) einem ersten Schaltungsteil (10) in ECL-Technologie mit einer Ausgangsstufe (11), die eine einen Referenzstrom ($I_1$) liefernde Stromquelle ($SQ_1$) aufweist und an ihren Ausgängen (A) ein komplementäres Ausgangssignal ($U_A$) zur Verfügung stellt,

b) einem zweiten Schaltungsteil (30) in MOS-Technologie mit einer Eingangsstufe (31), die von der gleichen Betriebsspannung ($U_B$) wie der erste Schaltungsteil (10) versorgt wird,

c) einem mit der Ausgangsstufe (11) des ersten Schaltungsteils (10) und der Eingangsstufe (31) des zweiten Schaltungsteils (30) verbundenen dritten Schaltungsteil (20) als ECL-MOS-Wandlerstufe zur Anpassung des MOS-Schaltungsteils (30) an den ECL-Schaltungsteil (10), mit einer mit den Ausgängen (A) der Ausgangsstufe (11) des ECL-Schaltungsteils (10) verbundenen Impedanzwandlerstufe (21), einer mit dem Ausgang der Impedanzwandlerstufe (21) verbundenen Verstärkerstufe (22) mit zwei in Gateschaltung betriebenen MOS-Verstärkertransistoren ($Q_5$, $Q_6$) und einer am Ausgang der Verstärkerstufe (22) angeschlossenen aktiven Lastschaltung (23), die den Signalausgang (OUT) der ECL-MOS-Wandlerstufe (20) bildet,
gekennzeichnet dadurch:

d) die ECL-MOS-Wandlerstufe (20) weist einen mit der Verstärkerstufe (22) verbundenen Referenzzweig (24) auf, der die Spannungsverhältnisse der Impedanzwandlerstufe (21), der Verstärkerstufe (22) und der ECL-Ausgangsstufe (11) nachbildet,

e) der Referenzzweig (24) besteht aus der Serienschaltung einer einen Referenzstrom ($I_2$) liefernden Stromquelle ($SQ_2$), eines MOS-Kompensationstransistors ($Q_9$), eines als Diode geschalteten Bipolar-Kompensationstransistors ($Q_{10}$) und eines an die Betriebsspannung ($U_B$) angeschlossenen Kompensations-Widerstands ($R_3$).

2. Schaltungsanordnung nach Anspruch 1, dadurch gekennzeichnet, daß die Ausgangsstufe (11) des ECL-Schaltungsteils (10) eine vom Referenzstrom ($I_1$) der Stromquelle ($SQ_1$) versorgte Differenzverstärkerstufe aus zwei Transistoren ($Q_1$, $Q_2$) mit Lastwiderständen ($R_1$, $R_2$) aufweist.

3. Schaltungsanordnung nach Anspruch 1 oder 2, dadurch gekennzeichnet, daß die Impedanzwandlerstufe (21) als Emitterfolger aus zwei Transistoren ($Q_3$, $Q_4$) mit gleicher Emitterfläche ($F_1$) ausgebildet

ist.

4. Schaltungsanordnung nach Anspruch 1 bis 3, dadurch gekennzeichnet, daß der Referenzstrom ($I_2$) der Stromquelle ($SQ_2$) des Referenzzweigs (24), das Kanalweiten-Kanallängen-Verhältnis ($W/L)_2$ des MOS-Kompensationstransistors ($Q_9$), die Emitterfläche ($F_2$) des Bipolar-Kompensationstransistors ($Q_{10}$) und die Größe des Kompensations-Widerstands ($R_3$) in einem festen vorgegebenen Verhältnis (n) zum Referenzstrom ($I_1$) der Stromquelle ($SQ_1$) der ECL-Ausgangsstufe (11), zum Kanalweiten-Kanallängen-Verhältnis ($W/L)_1$ der MOS-Verstärkertransistoren ($Q_5$, $Q_6$), zur Emitterfläche der Emitterfolger-Transistoren ($Q_3$, $Q_4$) der Impedanzwandlerstufe (21) und zu den Lastwiderständen ($R_1$, $R_2$) der ECL-Ausgangsstufe (11) stehen.

5. Schaltungsanordnung nach einem der Ansprüche 1 bis 4, dadurch gekennzeichnet, daß die Verstärkerstufe (22) zwei PMOS-Verstärkertransistoren ($Q_5$, $Q_6$) in Gate-Schaltung mit dem gleichen Kanalweiten-Kanallängen-Verhältnis ($W/L)_1$ aufweist.

6. Schaltungsanordnung nach einem der Ansprüche 1 bis 5, dadurch gekennzeichnet, daß die Lastschaltung (23) als Stromspiegelschaltung mit zwei NMOS-Transistoren ($Q_7$, $Q_8$) ausgebildet ist.

7. Schaltungsanordnung nach einem der Ansprüche 1 bis 6, dadurch gekennzeichnet, daß die Gate-Elektrode (G) des MOS-Kompensationstransistors ($Q_{10}$) des Referenzzweigs (24) mit dessen Drain-Elektrode (D) und mit den Gate-Elektroden (G) der beiden MOS-Verstärkertransistoren ($Q_5$, $Q_6$) der Verstärkerstufe (22) verbunden ist.

8. Schaltungsanordnung nach Anspruch 7, dadurch gekennzeichnet, daß der MOS-Kompensationstransistor ($Q_{10}$) des Referenzzweigs (24) und die beiden MOS-Verstärkertransistoren ($Q_5$, $Q_6$) der Verstärkerstufe (22) einen gemeinsamen Wannenanschluß (B) aufweisen.

9. Schaltungsanordnung nach Anspruch 8, dadurch gekennzeichnet, daß die gemeinsame Wanne (B) als N-Wanne ausgebildet ist.

**Claims**

1. A circuit arrangement including;

a) a first ECL-type circuit section (10) having an output stage (11) which comprises a current source ($SQ_1$) delivering a reference current ($I_1$), and which provides a complementary output signal ($U_A$) at its outputs (A),

b) a second MOS-type circuit section (30) having an input stage (31) which is supplied with the same operating voltage ($U_B$) as the first circuit section (10),

c) a third circuit section (20) in the form of an ECL-MOS converter stage for matching the MOS circuit section (30) to the ECL circuit section (10), said third circuit section being connected to the output stage (11) of the first circuit section (10) and to the input stage (31) of the second circuit section (30) and including an impedance converting stage (21) which is connected to the outputs (A) of the output stage (11) of the ECL circuit section (10), an amplifier stage (22) which is connected to the output of the impedance converting stage (21) and incorporates two MOS amplifier transistors ($Q_5$, $Q_6$) connected in common gate configuration, and an active load circuit (23) which is connected to the output of the amplifier stage (22) and forms the signal output (OUT) from the ECL-MOS converter stage (20), characterised in that

d) the ECL-MOS converter stage (20) comprises a reference branch (24) which is connected to the amplifier stage (22) and simulates the voltage conditions of the impedance converting stage (21), the amplifier stage (22) and the ECL output stage (11),

e) the reference branch (24) consists of the series circuit of a current source ($SQ_2$) delivering a reference current ($I_2$), an MOS compensating transistor ($Q_9$), a bipolar compensating transistor ($Q_{10}$) connected up as a diode, and a compensating resistance ($R_3$) which is connected to the operating voltage ($U_B$).

2. A circuit arrangement in accordance with Claim 1, characterised in that the output stage (11) of the ECL circuit section (10) comprises a differential amplifier stage which includes two transistors ($Q_1$, $Q_2$) and their load resistances ($R_1$, $R_2$) end is supplied with the reference current ($I_1$) from the current source ($SQ_1$).

3. A circuit arrangement in accordance with Claim 1 or 2, characterised in that the impedance converter stage (21) is in the form of an emitter follower consisting of two transistors ($Q_3$, $Q_4$) having the same emitter area ($F_1$).

4. A circuit arrangement in accordance with Claim 1 to 3, characterised in that the reference current ($I_2$) from the current source ($SQ_2$) in the reference branch (24), the channel width to channel length

ratio $(W/L)_2$ of the MOS compensating transistor ($Q_9$), the emitter area ($F_2$) of the bipolar compensating transistor ($Q_{10}$) and the magnitude of the compensating resistance ($R_3$) have a fixed predetermined relationship (n) with respect to the reference current ($I_1$) of the current source ($SQ_1$) in the ECL output stage (11), to the channel width to channel length ratio $(W/L)_1$ of the MOS amplifier transistors ($Q_5$, $Q_6$), to the emitter area of the emitter follower transistors ($Q_3$, $Q_4$) in the impedance converting stage (21) and to the load resistances ($R_1$, $R_2$) in the ECL output stage (11).

5. A circuit arrangement in accordance with any of the Claims 1 to 4, characterised in that the amplifier stage (22) comprises two PMOS amplifier transistors ($Q_5$, $Q_6$) which are connected in common gate configuration and have the same channel width to channel length ratio $(W/L)_1$.

6. A circuit arrangement in accordance with any of the Claims 1 to 5, characterised in that the load circuit (23) is in the form of a current mirror circuit incorporating two NMOS transistors ($Q_7$, $Q_8$).

7. A circuit arrangement in accordance with any of the Claims 1 to 6, characterised in that the gate electrode (G) of the MOS compensating transistor ($Q_{10}$) in the reference branch (24) is connected to its drain electrode (D), and to the gate electrodes (G) of the two MOS amplifier transistors ($Q_5$, $Q_6$) in the amplifier stage (22).

8. A circuit arrangement in accordance with Claim 7, characterised in that the MOS compensating transistor ($Q_{10}$) in the reference branch (24) and the two MOS amplifier transistors ($Q_5$, $Q_6$) in the amplifier stage (22) have a common well terminal (B).

9. A circuit arrangement in accordance with Claim 8, characterised in that the common well (B) is in the form of an N-type well.

**Revendications**

1. Montage comportant :

a) une première partie de circuit (10) réalisée selon la technologie ECL et comportant un étage de sortie (11), qui possède une source de courant ($SQ_1$), qui délivre un courant de référence ($I_1$) et fournit, sur ses sorties (A), un signal de sortie complémentaire ($U_A$),
b) une seconde partie de circuit (30) réalisée selon la technologie MOS et comportant un étage d'entrée (31), qui est alimenté par la même tension de service ($U_B$) que la première partie de circuit (10),

c) une troisième partie de circuit (20), qui est reliée à l'étage de sortie (11) de la première partie de circuit (10) et à l'étage d'encrée (31) de la seconde partie de circuit (30) et est agencée sous la forme d'un étage convertisseur ECL-MOS pour adapter la partie de circuit MOS (30) à la partie de circuit ECL (10), et comprenant un étage formant convertisseur d'impédance (21) relié aux sorties (A) de l'étage de sortie (11) de la partie de circuit ECL (10), un étage amplificateur (22) relié à la sortie de l'étage formant convertisseur d'impédance (21) et comportant deux transistors MOS amplificateurs ($Q_5$, $Q_6$) fonctionnant selon un montage en grille commune, et un circuit de charge actif (23), raccordé à la sortie de l'étage amplificateur (21) et formant le signal constituant la sortie de signal (OUT) de l'étage convertisseur ECL-MOS (20),

caractérisé en ce que :

d) l'étage convertisseur ECL-MOS (20) comporte une branche de référence (24), qui est relié à l'étage amplificateur (22) et qui simule les conditions de tension de l'étage convertisseur d'impédance (21), de l'étage amplificateur (22) et de l'étage de sortie ECL (11),

e) la branche de référence (24) est constituée par le circuit série formé d'une source de tension ($SQ_2$) délivrant un courant de référence ($I_2$), un transistor MOS de compensation ($Q_9$), un transistor bipolaire de compensation ($Q_{10}$) branché en diode et une résistance de compensation ($R_3$) raccordée à la tension de service ($U_B$).

2. Montage selon la revendication 1, caractérisé en ce que l'étage de sortie (11) de la partie de circuit ECL (10) comporte un étage amplificateur différentiel, qui est alimenté par le courant de référence ($I_1$) de la source de courant ($SQ_1$) et est constitué de deux transistors (Q1, $Q_2$) pourvus de résistances de charge ($R_1$, $R_2$).

3. Montage selon la revendication 1 ou 2, caractérisé en ce que l'étage formant convertisseur d'impédance (22) est agencé sous la forme d'un montage en émetteur suiveur constitué de deux transistors ($Q_3$, $Q_4$) possédant une même surface d'émetteur ($F_1$).

4. Montage selon les revendications 1 à 3, caractérise en ce que le courant de référence ($I_2$) de la source de courant ($SQ_2$) de la branche de référence (24), le rapport de la largeur à la longueur de canal ($W/L)_2$ du transistor MOS de compensation ($Q_9$), la surface d'émetteur ($F_1$) du transistor bipolaire de compensation ($Q_{10}$) et la valeur de la résistance de compensation ($R_3$) sont liés, selon un rapport fixe prédéterminé (n), au courant de référence ($I_1$) de la source de courant ($SQ_1$) de l'étage de sortie ECL (11), au rapport de la largeur à la longueur de canal ($W/L)_1$ des transistors amplificateurs MOS ($Q_5$, $Q_6$), à la surface d'émetteur des transistors ($Q_3$, $Q_4$) formant un montage en émetteur suiveur de l'étage formant convertisseur d'impédance (21) et aux résistances de charge ($R_1$, $R_2$) de l'étage de sortie ECL (11).

5. Montage selon l'une des revendications 1 à 4, caractérisé en ce que l'étage amplificateur (22) comporte deux transistors amplificateurs PMOS ($Q_5$,$Q_6$) branchés selon un montage en grille commune, avec le même rapport de la largeur à la longueur de canal ($W/L)_1$.

6. Montage selon l'une des revendications 1 à 5, caractérisé en ce que le circuit de charge (23) est agencé sous la forme d'un circuit formant miroir de courant comportant deux transistors NMOS ($Q_7$, $Q_8$).

7. Montage selon l'une des revendications 1 à 6, caractérisé en ce que l'électrode de grille (G) du transistor MOS de compensation ($Q_{10}$) de la branche de référence (24) est reliée à l'électrode de drain (D) de ce transistor et aux électrodes de grille (G) des deux transistors MOS amplificateurs ($Q_5$, $Q_6$) de l'étage amplificateur (22).

8. Montage selon la revendication 7, caractérisé en ce que le transistor MOS de compensation ($Q_{10}$) de la branche de référence (24) et les deux transistors amplificateurs MOS ($Q_5$, $Q_6$) de l'étage amplificateur (22) possèdent un raccord de cuvette commune (B).

9. Montage selon la revendication 8, caractérisé en ce que la cuvette commune (B) est agencée sous la forme d'une cuvette de type N.

FIG.1